# FASCICULE DE BREVET EUROPEEN

(11) **EP 0 848 493 B1**
(45) Date de publication et mention de la délivrance du brevet: **10.04.2002**
(21) Numéro de dépôt: 97402901.9
(22) Date de dépôt: 02.12.1997
(51) Int. Cl.: H03D 7/16

(54) **Dispositif électronique de traitement de signaux à large bande, avec transposition**
Elektronische Anordnung zur Verarbeitung von breitbandigen Signalen mit Frequenzumsetzung
Electronic device for processing wide band signals with frequency transposition

(30) Priorité: 11.12.1996 FR 9615231
(43) Date de publication de la demande: 17.06.1998
(73) Titulaire: THALES SYSTEMES AEROPORTES S.A., 78990 Elancourt (FR)
(72) Inventeur: Polaert, Jean, 78540 Vernouillet (FR); Fournier, Pierre, 78170 La Celle Saint Cloud (FR)
(74) Mandataire: Plaçais, Jean-Yves

(56) Documents cités:
- EP-A- 0 708 522
- WO-A-96/01006
- "Upgrading a Receiver with a Noise Source" MICROWAVE JOURNAL, vol. 36, no. 2, février 1993, DEDHAM US, pages 131-134, XP000363445

## Description

L'invention concerne le traitement des signaux de haute fréquence à large bande, les mots "haute fréquence" visant ici les fréquences de quelques GHz et plus, tandis que la large bande implique un rapport nettement supérieur à 1, entre la fréquence inférieure et la fréquence supérieure de la bande.

Lorsqu'on souhaite effectuer des traitements sur de tels signaux, il est généralement très difficile de mettre en oeuvre ces traitements sur les signaux tels quels. Il est donc connu d'effectuer sur les signaux une transposition, ou changement de fréquence (mélange amont), pour les ramener à une bande de fréquence plus basse, où les traitements sont plus commodes à effectuer. En règle générale, on procède ensuite à une nouvelle transposition ou changement de fréquence (mélange aval), pour faire remonter les signaux obtenus après traitement, dans les bandes de haute fréquence où ils sont utiles.

On sait qu'une transposition ou changement de fréquence s'effectue à partir d'un composant ayant des propriétés non linéaires, ce qui produit un nombre assez important de "produits de modulation". Un filtrage est nécessaire pour isoler celui de ces produits de modulation qui est intéressant.

Des solutions sont disponibles pour arriver à éliminer convenablement les produits de modulation indésirés, notamment lorsqu'on utilise des mélangeurs à bande latérale unique, dont les sorties (pour le mélangeur amont) et/ou les entrées (pour le mélangeur aval) travaillent sur deux composantes de signal, respectivement en phase et en quadrature.

Il est intéressant aujourd'hui que le traitement des signaux, entre le mélangeur amont et le mélangeur aval, soit réalisé après numérisation des signaux, qui sont ensuite à nouveau convertis sous forme analogique. Ceci crée une difficulté. En effet, le traitement lui-même, et aussi les limites de la numérisation (le pas de quantification) font que, après traitement, le signal possède un spectre complexe. Ce spectre contient un grand nombre de raies parasites, qu'il est difficile de filtrer. On remarquera en effet qu'il a déjà fallu filtrer les produits de modulation des mélangeurs eux-mêmes.

La présente invention a pour but d'apporter des éléments de solution à ce problème.

Le dispositif électronique proposé est du type connu comprenant:
- une entrée pour recevoir des signaux d'entrée analogiques de haute fréquence à traiter,
- un organe mélangeur amont, pour transposer les signaux à traiter vers une bande de fréquence plus basse,
- des moyens de traitement de ces signaux en bande basse, en particulier avec passage sous forme numérique et retour à la forme analogique, et
- un organe mélangeur aval, pour re-transposer les signaux traités dans une bande de haute fréquence désirée.

Selon un premier aspect de l'invention, ce dispositif comporte des moyens pour engendrer un signal auxiliaire, sensiblement aléatoire, et de bande de fréquence choisie, étroite relativement à celle des signaux à traiter; l'organe mélangeur amont comporte des moyens pour réaliser sur son signal transposé une modulation de phase selon ce signal auxiliaire; et l'organe mélangeur aval comporte également des moyens pour réaliser sur son signal transposé une démodulation de phase selon ce signal auxiliaire, compte tenu des modifications subies par le signal à traiter dans les moyens de traitement.

En principe, la modulation de phase est appliquée au signal d'oscillateur local de l'organe mélangeur amont, et la démodulation de phase est appliquée au signal d'oscillateur local de l'organe mélangeur aval.

Dans un mode de réalisation préférentiel particulièrement avantageux, les fréquences du signal d'oscillateur local de l'organe mélangeur amont et du signal d'oscillateur local de l'organe mélangeur aval sont égales, et la démodulation de phase prend en compte le retard subi par le signal à traiter dans les moyens de traitement.

Il est également avantageux que le signal d'oscillateur local de l'organe mélangeur aval subisse en outre un décalage de fréquence. Ce décalage de fréquence peut être ajouté par sommation sur le signal d'entrée du démodulateur de phase ou bien du modulateur de phase.

Selon un autre aspect de l'invention, le dispositif comprend des moyens pour ajouter aux signaux d'entrée un bruit de faible niveau, étalé sur une partie substantielle de la large bande à traiter.

L'invention convient tout particulièrement lorsque les moyens de traitement comprennent une conversion analogique/numérique, des moyens de traitement en numérique, et une conversion numérique/analogique, et lorsque l'organe mélangeur amont et l'organe mélangeur aval sont du type à bande latérale unique, tandis que les moyens de traitement travaillent sur deux voies, respectivement pour les composantes en phase et en quadrature des signaux transposés à traiter.

La conversion analogique/numérique (et son inverse, la conversion numérique/analogique) peuvent porter sur l'amplitude du signal à traiter, ou bien sur la phase du signal à traiter.

D'autres caractéristiques et avantages de l'invention apparaîtront à l'examen de la description détaillée ci-après, ainsi que des dessins annexés, sur lesquels :
- la figure 1 illustre le schéma de principe d'un exemple de dispositif connu ;
- la figure 2 illustre un dispositif muni d'une première caractéristique de l'invention ;
- la figure 3 illustre le schéma de principe d'un dispositif selon la figure 2, muni d'une seconde caractéristique de l'invention ;
- la figure 4 illustre le schéma de principe d'un dispositif muni d'une troisième caractéristique de l'invention; et
- la figure 5 représente une variante du dispositif qu'illustre la figure 3.

Les dessins annexés sont, pour l'essentiel, de caractère certain. En conséquence, ils pourront non seulement permettre de mieux comprendre la description, mais aussi contribuer à la définition de l'invention, le cas échéant.

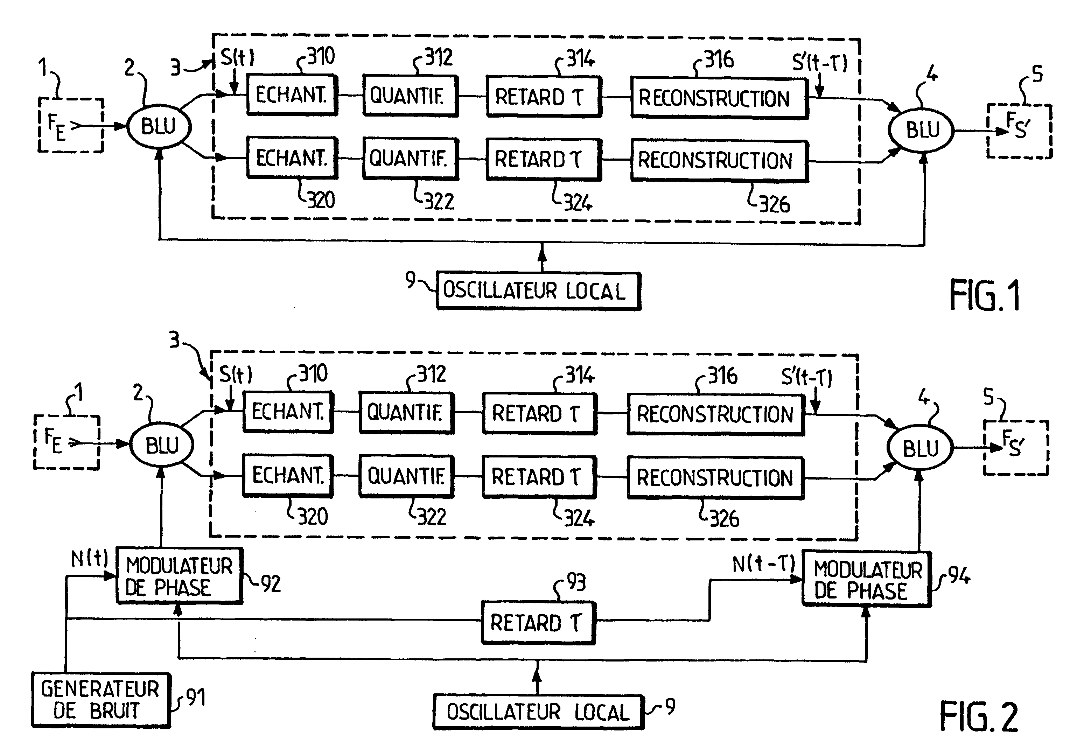

Sur la figure 1, une entrée 1 reçoit un signal d'entrée analogique F_{E}, qui possède par exemple une fréquence centrale de plusieurs GHz et une bande de fréquence instantanée de l'ordre du GHz.

Ce signal d'entrée F_{E} est appliqué à une première entrée d'un mélangeur 2, qui est ici à bande latérale unique ("BLU"). La seconde entrée du mélangeur 2 reçoit la sortie F_{OL} d'un oscillateur local 9.

Le mélangeur 2 est d'un type à deux sorties, respectivement en phase (voie supérieure) et en quadrature (voie inférieure), définissant ensemble les deux composantes d'un signal S(t), qui est un signal à traiter, ramené à une fréquence plus basse que celle du signal d'entrée F_{E}, afin de faciliter le traitement, de manière connue.

La voie supérieure, pour le signal "en phase" comporte d'abord un échantillonneur 310, suivi d'un quantificateur 312. L'ensemble de ces deux composants réalise une conversion analogique/numérique. Vient ensuite un circuit 314 réalisant un retard τ, variable. La voie se termine par un étage 316 de reconstruction du signal analogique, cette reconstruction consistant essentiellement en une conversion numérique/analogique.

La voie inférieure pour le signal "en quadrature" a la même constitution, et ses éléments sont désignés par les mêmes références numériques augmentées de dix unités.

Les sorties des deux voies définissent ensemble les deux composantes d'un signal S'(t-τ), qui est appliqué aux deux entrées d'un mélangeur BLU aval 4. Celui-ci reçoit ici la même fréquence de signal local en provenance de l'oscillateur 9 que le mélangeur 2 (la fréquence pourrait être différente). La sortie du mélangeur BLU aval 4 fournit le signal de sortie F_{S}, à l'étage de sortie 5.

Des moyens de traitement sont définis par l'ensemble des éléments 310 à 316 ainsi que 320 à 326; comme l'illustre le cadre en trait tireté, référencé 3. Si l'on fait abstraction des éléments qui permettent la conversion analogique/numérique, et la conversion numérique/analogique, le traitement proprement dit, au niveau numérique, s'effectue ici au niveau des circuits de retard 314 et 324, qui doivent appliquer le même retard aux deux composantes en phase et en quadrature.

On admet également que les caractéristiques des étages 310 et 320, 312 et 322, ainsi que 316 et 326, sont autant que possible identiques.

Comme déjà indiqué, il résulte de la numérisation un spectre complexe qui contient un grand nombre de raies parasites qu'il est difficile de filtrer.

La Demanderesse a recherché comment résoudre ce problème. Elle a observé que ces raies parasites deviennent beaucoup moins discernables, dès lors que l'on aura pu les étaler spectralement. Partant de là, elle a retenu deux moyens pour réaliser cette fonction d'étalement spectral. Bien que ces deux moyens soient utilisables individuellement, ils sont avantageusement combinés.

Le premier moyen sera maintenant décrit en référence à la figure 2. Entre l'oscillateur local 9 et les mélangeurs amont 2 et aval 4, on insère deux modulateurs de phase, respectivement 92 et 94. Les entrées de modulation de ces modulateurs sont tirées d'un générateur de bruit 91. Le générateur de bruit est relié directement au modulateur de phase 92. Il est relié à l'entrée de modulation du modulateur de phase 94 à travers un circuit de retard 93, qui fournit le même retard (en principe variable) que les circuits 314 et 324.

Bien que l'élément 94 soit techniquement un modulateur de phase, il est fait en sorte au niveau des signaux (de leur phase) qu'il réalise une démodulation de phase, c'est-à-dire qu'il vienne compenser, en sortie des moyens de traitement 3, l'effet de la modulation de phase effectuée précédemment à leur entrée. L'adaptation voulue du signe de la phase est effectuée ici au niveau des mélangeurs 2 et/ou 4, de sorte que les modulateurs de phase 92 et 94 sont identiques. Le mélangeur 2 donne F_{MF} = F_{E} - F_{OL}. Le mélangeur 4 donne F_{S}, = F_{OL} + F_{MF}.

Les travaux menés par la Demanderesse ont montré qu'un nombre important de raies parasites peuvent être étalées par ce premier moyen.

Si l'on suppose que la modulation de phase aléatoire est uniformément distribuée sur un intervalle de phase de 2π radians, avec un incrément de phase DPHI, le nombre de raies étalées dépend de la valeur de DPHI. Si DPHI = π/2, c'est-à-dire qu'on utilise une modulation de phase aléatoire d'incrément π/2, alors sont étalées la raie de l'oscillateur local (N = 0), la raie image N = -1, tandis que la raie utile N = 1 est intacte. N désigne ici l'ordre des harmoniques du signal d'entrée F_{E} qui sont étalées spectralement.

Si l'on passe à une modulation de phase aléatoire d'incrément DPHI = π/8, alors on obtient un étalement de toutes les raies parasites jusqu'aux rangs 16 et -14 inclus.

La Demanderesse a observé que ce premier moyen fonctionnait bien dans les conditions suivantes :
- La modulation de phase aléatoire doit se produire sur une bande de fréquence limitée vis-à-vis d'un sous-ensemble de la large bande considérée. On peut considérer par exemple que la bande de fréquence de la modulation de phase aléatoire est de l'ordre de la dizaine de MHz, tandis que le sous-ensemble précité de la large bande de fréquence globale pourrait être de l'ordre du GHz. Dans ces conditions, le débit du signal bruité N(t) qui réalise la modulation de phase est faible par rapport à celui du signal principal S(t). La surcharge qui en résulte au niveau des moyens de traitement 3 est alors relativement très faible, tant au niveau de la capacité de mémoire requise pour réaliser le retard variable dans les organes 314, 324 et 93, qu'au niveau de la bande instantanée traitée par les moyens de traitement.
- Du fait que le bruit de phase est additionné à l'entrée et retranché à la sortie, la puissance du signal utile en sortie reste pratiquement inchangée; il en est de même pour le rapport entre le signal utile et les autres signaux qui peuvent se trouver dans d'autres sous-ensembles de la large bande traitée.

La modulation de phase aléatoire a en outre l'effet que le spectre du signal qui traverse les moyens de traitement 3 est toujours l'objet d'un certain étalement spectral. Il devient donc possible de ne pas transmettre la composante continue, sans qu'il en résulte une altération sensible du signal à traiter; ceci est particulièrement vrai dans le cas où la fréquence de coupure basse des moyens de traitement est faible devant la bande spectrale de la modulation de phase aléatoire. Cette caractéristique a pour effet de faciliter la compensation des décalages ou "offsets" des différents composants des moyens de traitement, et en particulier des organes 310, 316, 320, 326 et 93.

Dans les dessins annexés, on a considéré le cas où les moyens de traitement opèrent sur une voie "en phase" et une voie "en quadrature", ce que l'on appelle également "traiter un signal complexe" (au sens de la représentation de signaux sinusoïdaux par des nombres complexes). Toutefois, on peut se contenter d'une seule voie, en codant le signal sous forme réelle.

De son côté, la conversion analogique/numérique ou codage (et naturellement l'opération inverse), peut porter sur le niveau du signal, c'est-à-dire que l'on traite son amplitude instantanée. Cette numérisation ou codage peut également porter sur la phase du signal, uniquement, auquel cas les moyens de traitement 3 fonctionnent en limiteurs d'amplitude, avec naturellement la perte de l'information amplitude instantanée. Ce second mode de fonctionnement est intéressant pour certaines applications.

Selon un autre aspect de l'invention, le mode de réalisation de la figure 2 permet aussi, d'une façon très simple et économique, l'application d'une variation de fréquence au signal de sortie. En amont de l'un des modulateurs de phase, et sur l'une des entrées de celui-ci, on ajoute un additionneur qui reçoit la fréquence de décalage.

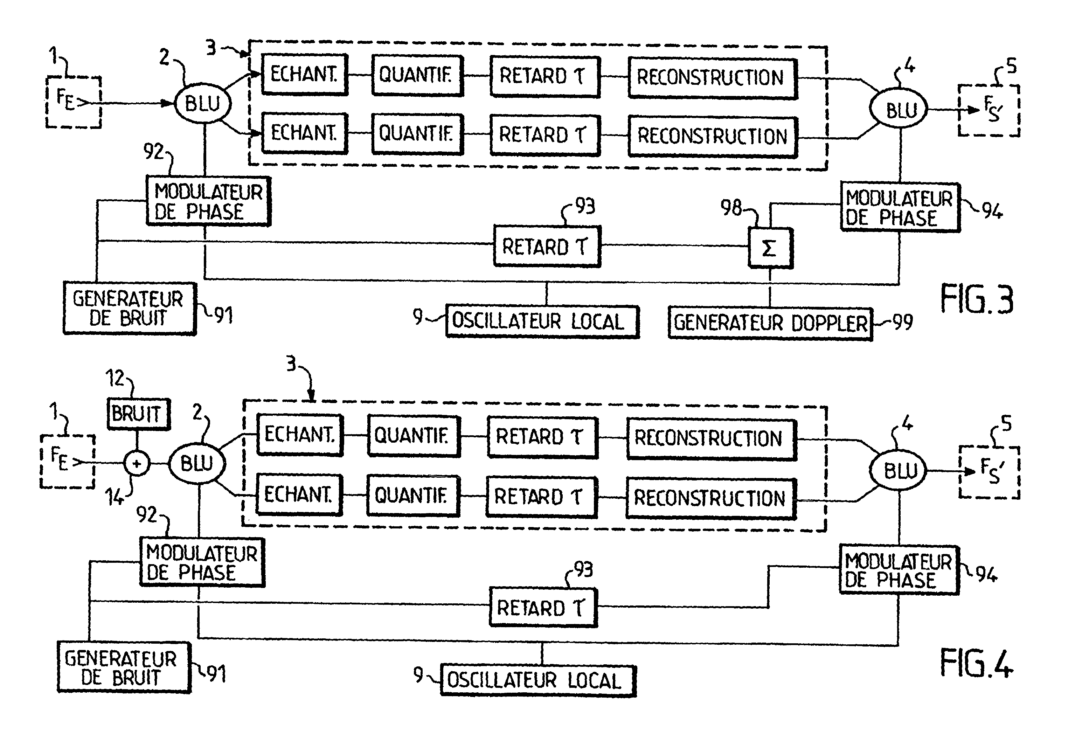

Dans un exemple particulier (figure 3), c'est l'entrée de modulation du modulateur de phase 94 qui reçoit, après le circuit de retard 93, un sommateur numérique 98, dont l'autre entrée est alimentée par un générateur Doppler 99.

Il est rappelé que la modulation de phase est quantifiée selon un pas DPHI. C'est pourquoi les modulateur et démodulateur de phase sont à commande numérique.

Ce mode de réalisation permet d'appliquer de façon certaine le même décalage de fréquence alors qu'on a deux voies dans les moyens de traitement. Il en résulte en outre une très bonne réjection de la fuite du signal d'entrée non transposé en fréquence Doppler, ainsi que de la fréquence image associée.

On considérera maintenant un autre aspect de l'invention.

De façon générale, il est connu que l'addition de bruit à l'entrée d'un codeur ou convertisseur analogique/numérique permet de linéariser le fonctionnement de ce codeur.

Si l'on considère par exemple un système qui code son signal d'entrée sur huit états de phase différents (3 bits), ce système va présenter des raies harmoniques d'ordres 7 et 9, dues essentiellement à ce codage, avec des niveaux situés respectivement à environ 17 et 19 dBc par rapport à la raie fréquentielle utile. (Le symbole "dBc" rappelle qu'il s'agit d'un rapport entre le signal utile et la raie parasite).

L'addition d'un bruit en entrée du codeur, avec par exemple un rapport signal/bruit de l'ordre de 7,5 dB fait descendre le niveau des raies harmoniques 7 et 9 à -32 et -40 dBc sous la raie fréquentielle utile, respectivement.

La simplicité et la robustesse de ce dispositif sont connues. Mais il est également connu qu'il présente un inconvénient majeur : en additionnant un bruit au signal d'entrée, on dégrade le rapport signal/bruit, et l'on réduit la puissance du signal utile.

Toutefois, la Demanderesse a observé que cet autre moyen est intéressant pour la mise en oeuvre de l'invention, en particulier dans le cas où les moyens de traitement travaillent avec un codage en phase du signal, comme indiqué plus haut. En effet, dans ce cas, il est aisé de faire en sorte que le rapport signal/bruit reste constant. La puissance du signal à l'entrée du dispositif est elle-même rendue préalablement constante, par exemple à l'aide d'un amplificateur-limiteur.

En utilisant conjointement le moyen décrit à propos de la figure 2, et l'addition de bruit sur le signal d'entrée, on obtient le montage illustré sur la figure 4. La source de bruit 12, qui est cette fois à large bande, est appliquée par un additionneur analogique 14 au signal d'entrée F_{E}, avant l'entrée du mélangeur 2 à bande latérale unique.

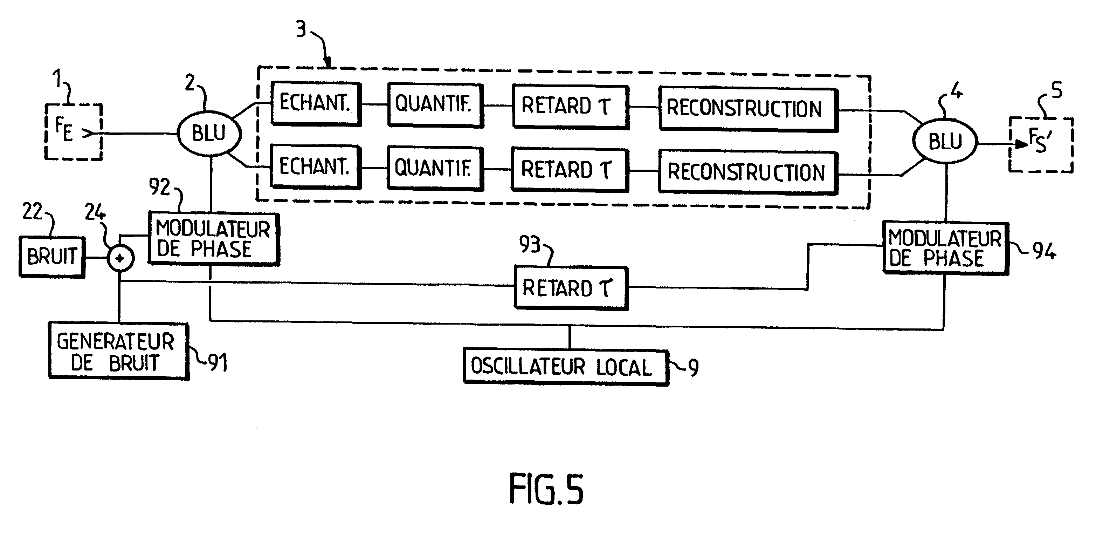

Une variante possible du dispositif de la figure 3 est illustrée sur la figure 5.

La source de bruit 22 est, dans cette variante, additionnée, à l'aide d'un additionneur 24, au signal fourni par le générateur de bruit 92 à travers le circuit de retard 93. Ici, c'est la sortie de l'additionneur 24 qui sert de signal de commande du modulateur de phase 92.

Avec ce montage, il devient possible d'obtenir de meilleures performances, pour un incrément de phase donné du système de modulation/démodulation de phase aléatoire.

Un modulateur à huit états de phase (3 bits) procure avec le montage de la figure 2 un étalement de toutes les raies parasites jusqu'aux rangs -6 et 8 inclus.

En utilisant conjointement les deux moyens, à savoir la modulation/démodulation de phase aléatoire d'une part, et l'adjonction d'un bruit additionnel à l'entrée, comme illustré sur les figures 4 et 5, on peut, avec un codeur simple à large bande possédant seulement huit états de phase, c'est-à-dire codant sur 3 bits, obtenir des performances notablement améliorées, qui correspondraient pratiquement au recours à un modulateur/démodulateur de phase aléatoire qui serait quatre fois plus précis.

Ainsi, les deux moyens proposés selon l'invention se combinent pour aboutir d'une manière particulièrement intéressante à la solution du problème posé. Il n'en reste pas moins que ces moyens peuvent être utilisés individuellement.

Sur un autre plan, ces moyens combinés donnent les meilleurs résultats dans le cas où la conversion analogique/numérique porte sur la phase du signal; en effet, ce codage est plus facile à mettre en oeuvre. Mais il est également concevable de les utiliser ensemble, avec les mêmes avantages, dans un système à codage d'amplitude.

Les dispositifs proposés selon la présente invention ont pour intérêt non seulement d'améliorer la pureté spectrale du signal de sortie, considéré en lui-même, mais aussi de réduire très sensiblement la pollution électromagnétique qui peut être engendrée par les raies parasites avoisinantes. Cela est particulièrement intéressant pour certaines applications.

Quoique cela ne soit pas illustré sur les figures 4 et 5, celles-ci peuvent également recevoir l'addition d'un décalage de fréquence par des moyens 98 et 99, comme illustré sur la figure 3, ou bien selon une autre des manières envisagées à propos de cette figure 3.

Bien entendu, l'invention n'est pas limitée au mode de réalisation décrit. Par exemple, elle ne s'applique pas nécessairement au seul cas où l'on effectue une conversion analogique-numérique avant traitement.

## Revendications

1. Dispositif électronique de traitement de signaux de haute fréquence à large bande, du type comprenant:
- une entrée (1) pour recevoir des signaux d'entrée analogiques de haute fréquence à traiter,
- un organe mélangeur amont (2), pour transposer les signaux à traiter vers une bande de fréquence plus basse,
- des moyens (3) de traitement de ces signaux en bande basse, en particulier avec passage sous forme numérique et retour à la forme analogique, et
- un organe mélangeur aval (4), pour re-transposer les signaux traités dans une bande de haute fréquence désirée,
**caractérisé en ce qu'**il comporte des moyens (91) pour engendrer un signal auxiliaire, sensiblement aléatoire, et de bande de fréquence choisie, étroite relativement à celle des signaux à traiter,
**en ce que** l'organe mélangeur amont comporte des moyens (92) pour réaliser sur son signal transposé une modulation de phase selon ce signal auxiliaire, et
**en ce que** l'organe mélangeur aval comporte également des moyens (94) pour réaliser sur son signal transposé une démodulation de phase selon ce signal auxiliaire, compte tenu des modifications subies par le signal à traiter dans les moyens de traitement.

2. Dispositif selon la revendication 1, **caractérisé en ce que** la modulation de phase est appliquée au signal d'oscillateur local de l'organe mélangeur amont, et **en ce que** la démodulation de phase est appliquée au signal d'oscillateur local de l'organe mélangeur aval.

3. Dispositif selon l'une des revendications 1 et 2, **caractérisé en ce que** les fréquences du signal d'oscillateur local de l'organe mélangeur amont et du signal d'oscillateur local de l'organe mélangeur aval sont égales, et **en ce que** la démodulation de phase prend en compte le retard (τ) subi par le signal à traiter dans les moyens de traitement.

4. Dispositif selon l'une des revendications précédentes, **caractérisé en ce que** le signal d'oscillateur local de l'organe mélangeur aval subit en outre un décalage de fréquence (98,99).

5. Dispositif selon la revendication 4, **caractérisé en ce que** le décalage de fréquence est ajouté par sommation (98) sur le signal d'entrée des moyens de modulation de phase (92) ou des moyens de démodulation (94) de phase.

6. Dispositif selon l'une des revendications précédentes, **caractérisé en ce qu'**il comprend des moyens (12,14) pour ajouter aux signaux d'entrée un bruit de faible niveau, étalé sur une partie substantielle de la large bande à traiter.

7. Dispositif selon l'une des revendications précédentes, **caractérisé en ce que** les moyens de traitement comprennent des moyens de conversion analogique/numérique (310,312), des moyens de traitement en numérique (314), et des moyens de conversion numérique/analogique (316).

8. Dispositif selon la revendication 7, **caractérisé en ce que** l'organe mélangeur amont (2) et l'organe mélangeur aval (4) sont du type à bande latérale unique, et **en ce que** les moyens de traitement travaillent sur deux voies, respectivement pour les composantes en phase (310-316) et en quadrature (320-326) des signaux transposés à traiter.

9. Dispositif selon l'une des revendications 7 et 8, **caractérisé en ce que** la conversion analogique/numérique (310,312,320,322) et la conversion numérique/analogique (316,326) portent sur l'amplitude du signal à traiter.

10. Dispositif selon l'une des revendications 7 et 8, **caractérisé en ce que** la conversion analogique/numérique (310,312,320,322) et la conversion numérique/analogique (316,326) portent sur la phase du signal à traiter.

11. Dispositif selon l'une des revendications 3 à 10, **caractérisé en ce qu'**il comporte des moyens (313,314,93) pour faire varier le retard (τ).

## Claims

1. Electronic device for processing high-frequency broadband signals, of the type comprising:
- an input (1) for receiving high-frequency analogue input signals to be processed,
- an upstream mixer unit (2), for transposing the signals to be processed to a lower frequency band,
- means (3) of processing these low-band signals, in particular with switchover to digital form and return to the analogue form, and
- a downstream mixer unit (4), for retransposing the processed signals into a desired high-frequency band,
**characterized in that** it comprises means (91) for generating a substantially random, auxiliary signal of chosen frequency band, which band is narrow relative to that of the signals to be processed,
and **in that** the upstream mixer unit comprises means (92) for carrying out on its transposed signal a phase modulation according to this auxiliary signal, and
**in that** the downstream mixer unit also comprises means (94) for carrying out on its transposed signal a phase demodulation according to this auxiliary signal, having regard to the modifications undergone by the signal to be processed in the processing means.

2. Device according to Claim 1, **characterized in that** the phase modulation is applied to the local oscillator signal of the upstream mixer unit, and **in that** the phase demodulation is applied to the local oscillator signal of the downstream mixer unit.

3. Device according to either of Claims 1 and 2, **characterized in that** the frequencies of the local oscillator signal of the upstream mixer unit and of the local oscillator signal of the downstream mixer unit are equal, and **in that** the phase demodulation takes into account the delay (τ) undergone by the signal to be processed in the processing means.

4. Device according to one of the preceding claims, **characterized in that** the local oscillator signal of the downstream mixer unit furthermore undergoes a frequency shift (98, 99).

5. Device according to Claim 4, **characterized in that** the frequency shift is added by summation (98) to the input signal of the phase modulation means (92) or of the phase demodulation means (94).

6. Device according to one of the preceding claims, **characterized in that** it comprises means (12, 14) for adding low-level noise, spread over a substantial part of the broadband to be processed, to the input signals.

7. Device according to one of the preceding claims, **characterized in that** the processing means comprise analogue/digital conversion means (310, 312), means of processing in digital (314), and digital/ analogue conversion means (316).

8. Device according to Claim 7, **characterized in that** the upstream mixer unit (2) and the downstream mixer unit (4) are of the single sideband type, and **in that** the processing means work on two paths, respectively for the in-phase component (310-316) and quadrature component (320-326) of the transposed signals to be processed.

9. Device according to either of Claims 7 and 8, **characterized in that** the analogue/digital conversion (310, 312, 320, 322) and the digital/analogue conversion (316, 326) pertain to the amplitude of the signal to be processed.

10. Device according to either of Claims 7 and 8, **characterized in that** the analogue/digital conversion (310, 312, 320, 322) and the digital/analogue conversion (316, 326) pertain to the phase of the signal to be processed.

11. Device according to one of Claims 3 to 10, **characterized in that** it comprises means (313, 314, 93) for varying the delay (τ).

## Patentansprüche

1. Elektronische Vorrichtung zur Verarbeitung von Breitbandhochfrequenzsignalen vom Typ aufweisend:
- einen Eingang (1) um analoge Hochfrequenzeingangssignale zu empfangen, die zu verarbeiten sind,
- ein stromaufwärts liegendes Mischorgan (2), um die zu verarbeitenden Signale in ein niedrigeres Frequenzband zu transponieren,
- eine Einrichtung (3) zur Verarbeitung dieser Signale im niedrigen Band, insbesondere mit Übergang in digitaler Form und Rückkehr in die analoge Form und
- ein stromabwärts liegendes Mischorgan (4), um die verarbeiteten Signale in ein gewünschtes Hochfrequenzband zurückzutransponieren.
**dadurch gekennzeichnet, dass** sie eine Einrichtung (91) aufweist, um ein im wesentlichen zufälliges Hilfssignal eines gewählten Frequenzbands zu erzeugen, welches relativ nahe demjenigen der zu verarbeitenden Signale ist,
dass das stromaufwärts liegende Mischorgan eine Einrichtung (92) aufweist, um an seinem transponierten Signal eine Phasenmodulation entsprechend diesem Hilfssignal auszuführen und
dass das stromabwärts liegende Mischorgan ebenfalls eine Einrichtung (94) aufweist, um an seinem transponierten Signal eine Phasendemodulation entsprechend diesem Hilfssignal unter Berücksichtigung der durch das Signal durchgemachten Modifikationen auszuführen, das in der Verarbeitungseinrichtung zu verarbeiten ist.

2. Vorrichtung nach Anspruch 1,
**dadurch gekennzeichnet, dass** die Phasenmodulation auf das lokale Oszillatorsignal des stromaufwärts liegenden Mischorgans angewendet wird und dass die Phasendemodulation auf das lokale Oszillatorsignal des stromabwärts liegenden Mischorgans angewendet wird.

3. Vorrichtung nach Anspruch 1 oder 2,
**dadurch gekennzeichnet, dass** die Frequenzen des lokalen Oszillatorsignals des stromaufwärts liegenden Mischorgans und des lokalen Oszillatorsignals des stromabwärts liegenden Mischorgans gleich sind und dass die Phasendemodulation die durch das Signal durchgemachte Verzögerung (93 τ) berücksichtigt, das in der Verarbeitungseinrichtung zu verarbeiten ist.

4. Vorrichtung nach einem der vorstehenden Ansprüche,
**dadurch gekennzeichnet, dass** das lokale Oszillatorsignal des stromabwärts liegenden Mischorgans außerdem eine Frequenzverschiebung (98, 99) durchmacht.

5. Vorrichtung nach Anspruch 4,
**dadurch gekennzeichnet, dass** die Frequenzverschiebung durch Summierung (98) dem Eingangssignal der Phasenmodulationseinrichtung (92) oder der Phasendemodulationseinrichtung (94) hinzugefügt wird.

6. Vorrichtung nach einem der vorstehenden Ansprüche,
**dadurch gekennzeichnet, dass** sie Einrichtungen (12, 14) aufweist, um den Eingangssignalen ein Geräusch niedrigen Pegels hinzuzufügen, das sich auf einem wesentlichen Teil des zu verarbeitenden breiten Bands erstreckt.

7. Vorrichtung nach einem der vorstehenden Ansprüche,
**dadurch gekennzeichnet, dass** die Verarbeitungseinrichtungen Einrichtungen zur A/D-Umwandlung (310, 312), Einrichtungen zur digitalen Verarbeitung (314) und eine Einrichtung zur D/A-Umwandlung (316) aufweisen.

8. Vorrichtung nach Anspruch 7,
**dadurch gekennzeichnet, dass** das stromaufwärts liegende Mischorgan (2) und das stromabwärts liegende Mischorgan (4) vom Einseitenbandtyp sind und dass die Verarbeitungseinrichtungen auf zwei Kanälen arbeiten, jeweils für die Inphasekomponenten (310-316) und die phasenverschobenen Komponenten (320-326) der zu verarbeitenden transponierten Signale.

9. Vorrichtung nach Anspruch 7 oder 8,
**dadurch gekennzeichnet, dass** sich die A/D-Umwandlung (310, 312, 320, 322) und die D/A-Umwandlung (316, 326) auf die Amplitude des zu verarbeitenden Signals erstrecken.

10. Vorrichtung nach Anspruch 7 oder 8,
**dadurch gekennzeichnet, dass** sich die A/D-Umwandlung (310, 312, 320, 322) und die D/A-Umwandlung (316, 326) auf die Phase des zu verarbeitenden Signals erstrecken.

11. Vorrichtung nach einem der Ansprüche 3 bis 10,
**dadurch gekennzeichnet, dass** sie Einrichtungen (313, 314, 93) aufweist, um die Verzögerung (τ) zu variieren.
